# EUROPEAN PATENT SPECIFICATION

(11) **EP 4 310 485 B1**
(45) Date of publication and mention of the grant of the patent: **18.03.2026**
(21) Application number: 22186329.3
(22) Date of filing: 21.07.2022
(51) Int. Cl.: G01N 23/2252, H01J 37/22, H01J 37/28, G01N 23/2206, G01N 23/2208, G06T 7/11, G06T 7/187

(54) **METHOD OF EXAMINING A SAMPLE USING A CHARGED PARTICLE MICROSCOPE**
VERFAHREN ZUR UNTERSUCHUNG EINER PROBE MIT EINEM LADUNGSTRÄGERMIKROSKOP
PROCÉDÉ D'EXAMEN D'UN ÉCHANTILLON À L'AIDE D'UN MICROSCOPE À PARTICULES CHARGÉES

(43) Date of publication of application: 24.01.2024
(73) Proprietor: FEI Company, Hillsboro, OR 97124-5793 (US)
(72) Inventor: KLUSACEK, Jan, Hillsboro (US); HLAVENKA, Petr, Hillsboro (US); VANATKA, Marek, Hillsboro (US); VAVERKA, Ondrej, Hillsboro (US)
(74) Representative: Janssen, Francis-Paul

(56) References cited:
- EP-A1- 3 614 414
- EP-A1- 3 745 442
- US-A1- 2011 144 922

## Description

The invention relates to a method of examining a sample using a charged particle microscope, comprising the steps of detecting using a first detector emissions of a first type from the sample in response to a charged particle beam scanned over the area of the sample, and using spectral information of detected emissions of the first type for examining said sample.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" apparatus (e.g. a FIB-SEM), which additionally employ a "machining" Focused Ion Beam (FIB), allowing supportive activities such as ion-beam milling or Ion-Beam-Induced Deposition (IBID), for example. The skilled person will be familiar with the different species of charged particle microscopy.

Irradiation of a sample by a scanning electron beam precipitates emanation of "auxiliary" radiation from the sample, in the form of secondary electrons, backscattered electrons, X-rays and cathodoluminescence (infrared, visible and/or ultraviolet photons). One or more components of this emanating radiation may be detected and used for sample analysis.

Typically, in a SEM backscattered electrons are detected by a solid state detector in which each backscattered electron is amplified as it creates many electron-hole pairs in a semiconductor detector. The backscattered electron detector signal is used to form an image as the beam is scanned, with the brightness of each image point determined by the number of backscattered electrons detected at the corresponding point on the sample as the primary beam moves across the sample. The image merely provides information on the topology of the sample to be examined.

In a process called "energy dispersive x-ray spectroscopy" or "EDS", the energies of x-rays coming from the sample in response to the electron beam are measured and plotted in a histogram to form a material specific spectrum. The measured spectrum can be compared to known spectra of various elements to determine which elements and minerals are present in said sample.

During EDS mapping individual x-ray counts are detected and registered to the pixel they have originated from. As an EDS spectrum can be processed to get chemical composition (or chemical characterization of a sample, in general), it is (in principle) possible to calculate the concentration of a single element for each pixel and display this in an element map. Typically, a grid with discrete analysis points is used. The electron beam dwells on each analysis point while the EDS detectors record x-rays. Once sufficient x-ray counts are recorded the beam moves to the next analysis point. The signal from the EDS detectors is fed to a signal processing unit that builds an x-ray spectrum curve for each analysis point, which can be matched to an extensive library of known mineral phases to select the best match for that analysis point. Quantification requires spectra with enough counts to get accurate results and acquiring dense spectra is time-consuming and not always possible. Because of that the counts from several close pixels are often binned together, sacrificing spatial resolution for chemical accuracy. The optimal size of this binning depends on total amount of data and use-case. Larger bins produce images with lower spatial resolution but also lower noise.
EP3745442 describes a method of examining a sample using a charged particle microscope, comprising the steps of providing a charged particle beam, as well as a sample 50,150; scanning said charged particle beam over said sample at a plurality of sample locations; and detecting, using a first detector, emissions of a first type from the sample in response to the beam scanned over the plurality of sample locations.

It is an object of the present invention to provide an improved method of examining a sample using a charged particle microscope, wherein spectral information of detected emissions is used for examining said sample. In particular, it is an object of the present invention to provide a method and apparatus for more rapidly and more accurately acquiring information about a sample.

To this end, the invention provides a method of examining a sample using a charged particle microscope as defined in claim 1.

The method as defined herein comprises the steps of providing a charged particle beam and scanning said beam over an area of the sample, detecting spectral emissions from the sample in response to the charged particle beam being scanned over the area of the sample, and identifying a first plurality of substantially similar spectral emissions, at different points of the scan, and determining a first chemical element associated with said first plurality of substantially similar spectral emissions.

The method as defined herein is characterized by the step of providing a first base spectral number value associated with said first determined chemical element. This first base spectral number value is related to the number of similar spectral emissions that are required for confidently determining said first chemical element.

The method as defined herein is further characterized by the step of dividing at least a part of the scanned area of the sample into a first number of segments associated with said first chemical element, wherein said first base spectral number value is used for defining a size of each of said first number of segments.

The method further provides a graphical representation of the sample, wherein said graphical representation includes said first chemical element and corresponding segments.

In this method, the first base spectral number value thus acts as a binning parameter that determines the substantially optimal size of binning for the first determined chemical element. Inventors realized that this binning parameter may be different for different chemical elements. The inventors found that the error in quantification is proportional to the (square root of the) absolute number of counts in an element's peak (net counts). Thus, net counts can be used as a criterion for segment activation. This way, elements with a variable concentration are rendered in with high resolution in high concentration areas, and with lower resolution in lower concentration areas. Additionally, the method allows trace elements to be correctly displayed.

The method according to claim 1, further comprises the step of identifying a second plurality of substantially similar spectral emissions and determining a second chemical element associated with said second plurality of substantially similar spectral emissions. Then, a second base spectral number value associated with said second determined chemical element may be provided, wherein said second base spectral number value is related to the number of similar spectral emissions that are required for confidently determining said second chemical element. With this, at least a part of the scanned area of the sample may be divided into a second number of segments associated with said second chemical element, wherein said second base spectral number value is used for defining a size of each of said second number of segments.

The second base spectral number value is different from said first base spectral number value, and said size of each of said second number of segments is different from said size of each of said first number of segments. This means that segments can vary in size, not only within the first number of segments, but only between the first number and the second number of segments.

When at least a plurality of chemical elements are to be identified, the method may comprise the step of identifying at least one further plurality of substantially similar spectral emissions and determining a further chemical element associated with said further plurality of substantially similar spectral emissions. The method may then comprise the step of providing, for each of the at least one further chemical elements, a respective further base spectral number value associated with said respective further determined chemical element, wherein said respective further base spectral number value is related to the number of similar spectral emissions that are required for confidently determining said respective further chemical element. Finally, at least a part of the scanned area of the sample may be divided into a corresponding set of further number of segments, each set associated with a respective further chemical element, wherein said further base spectral number value is used for defining a size of each of said corresponding further number of segments.

In effect, the use of a first, second, and/or further base spectral number value, which may be different for the first, second, and/or further chemical elements, leads to the selection of different spatial resolution separately for each element based on its presence.

It is noted that the method may comprise the step of updating and/or modifying at least one segment in response to the beam being scanned over the sample. Thus, as more data is coming in, the size and shape of segments can be changed and/or updated to improve the accuracy of the graphical representation.

According to an aspect of the invention, a charged particle microscope for examining a sample using the method as described above is provided. The apparatus as defined herein comprises:
- an optics column, including a charged particle source, a final probe forming lens and a scanner, for focusing a beam of charged particles emitted from said charged particle source onto a sample;
- a sample stage positioned downstream of said final probe forming lens and arranged for holding said sample;
- a first detector, such as an EDS detector, for detecting emissions of a first type originating from said sample in response to the incidence of charged particles emitted from said charged particle source; and
- a control unit and a processing device connected to said first detector.

According to the invention, said charged particle microscope is arranged for executing the method according to the invention as defined above. Thus, an apparatus is obtained with which information about the sample can be acquired in a more rapid and/or more accurate way. Thus, the object of the invention is achieved.

The invention will now be elucidated in more detail on the basis of exemplary embodiments and the accompanying schematic drawings, in which:
Fig. 1 - shows a longitudinal cross-sectional view of a charged particle microscope according to a first embodiment of the invention;
Fig. 2 - shows a longitudinal cross-sectional view of a charged particle microscope according to a second embodiment of the invention;
Fig. 3 - shows a schematic overview of an embodiment of the method according to the invention;
Fig. 4 - shows a schematic overview of a further embodiment of the method according to the invention;
Fig. 5 - shows a schematic overview of another embodiment of the method according to the invention;

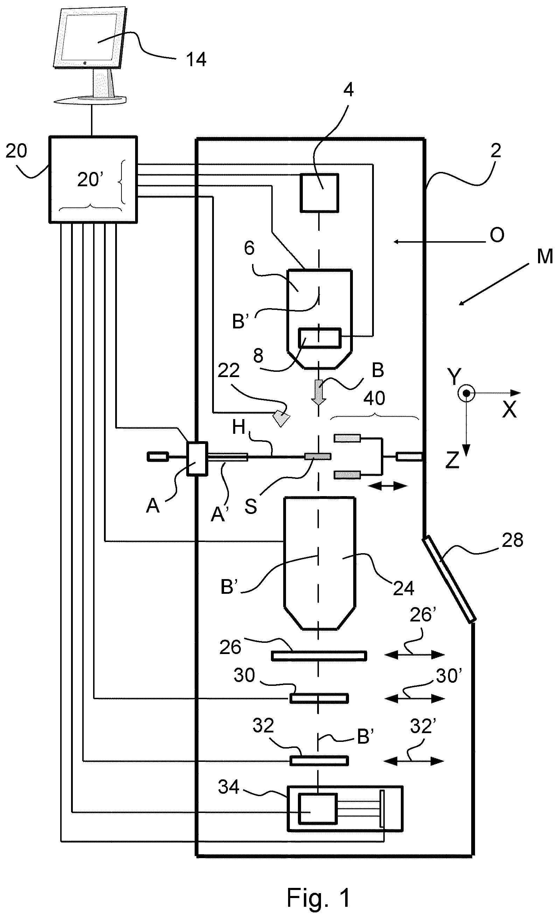

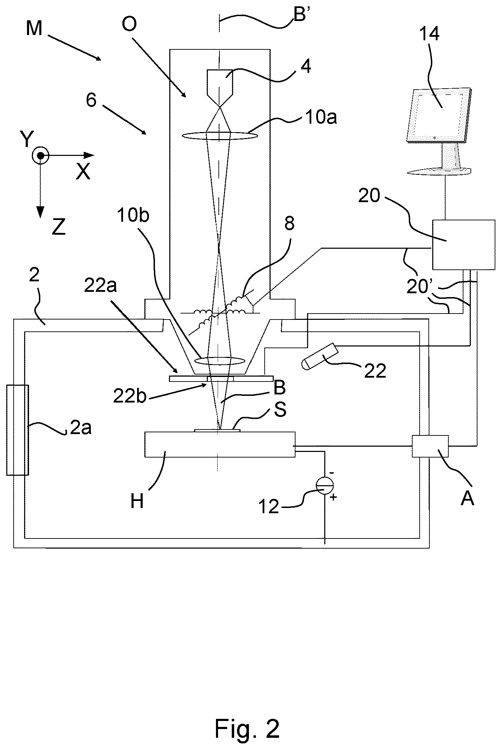

Fig. 1 (not to scale) is a highly schematic depiction of an embodiment of a charged-particle microscope M according to an embodiment of the invention. More specifically, it shows an embodiment of a transmission-type microscope M, which, in this case, is a TEM/STEM (though, in the context of the current invention, it could just as validly be a SEM (see Figure 2), or an ion-based microscope, for example). In Fig. 1, within a vacuum enclosure 2, an electron source 4 produces a beam B of electrons that propagates along an electron-optical axis B' and traverses an electron-optical illuminator 6, serving to direct/focus the electrons onto a chosen part of a sample S (which may, for example, be (locally) thinned/planarized). Also depicted is a deflector 8, which (*inter alia*) can be used to effect scanning motion of the beam B.

The sample S is held on a sample holder H that can be positioned in multiple degrees of freedom by a positioning device / stage A, which moves a cradle A' into which holder H is (removably) affixed; for example, the sample holder H may comprise a finger that can be moved (*inter alia*) in the XY plane (see the depicted Cartesian coordinate system; typically, motion parallel to Z and tilt about X/Y will also be possible). Such movement allows different parts of the sample S to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the sample holder H, so as to maintain it (and the sample S thereupon) at cryogenic temperatures, for example.

The electron beam B will interact with the sample S in such a manner as to cause various types of "stimulated" radiation to emanate from the sample S, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the sample S, exit/emanate from it and continue to propagate (substantially, though generally with some deflection/scattering) along axis B'. Such a transmitted electron flux enters an imaging system (projection lens) 24, which will generally comprise a variety of electrostatic / magnetic lenses, deflectors, correctors (such as stigmators), *etc.* In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of ) the sample S will be formed by imaging system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving imaging system 24 is generally quite large (*e.g.* of the order of 1 meter). Consequently, various other types of analysis apparatus can be used downstream of screen 26, such as:
- TEM camera 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
- STEM camera 32. An output from camera 32 can be recorded as a function of (X,Y) scanning position of the beam B on the sample S, and an image can be constructed that is a "map" of output from camera 32 as a function of X,Y. Camera 32 can comprise a single pixel with a diameter of *e.g*. 20 mm, as opposed to the matrix of pixels characteristically present in camera 30. Moreover, camera 32 will generally have a much higher acquisition rate (*e.g.* 10⁶ points per second) than camera 30 (*e.g.* 10² images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).
- As an alternative to imaging using cameras 30 or 32, one can also invoke spectroscopic apparatus 34, which could be an EELS module, for example.

It should be noted that the order/location of items 30, 32 and 34 is not strict, and many possible variations are conceivable. For example, spectroscopic apparatus 34 can also be integrated into the imaging system 24.

In the embodiment shown, the microscope M further comprises a retractable X-ray Computed Tomography (CT) module, generally indicated by reference 40. In Computed Tomography (also referred to as tomographic imaging) the source and (diametrically opposed) detector are used to look through the sample along different lines of sight, so as to acquire penetrative observations of the sample from a variety of perspectives.

Note that the controller (computer processor) 20 is connected to various illustrated components *via* control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum; for example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (*e.g*. of the order of 1 cm in diameter) through which the employed electron beam passes, but widening out to accommodate structures such as the source 4, sample holder H, screen 26, camera 30, camera 32, spectroscopic apparatus 34, *etc.*

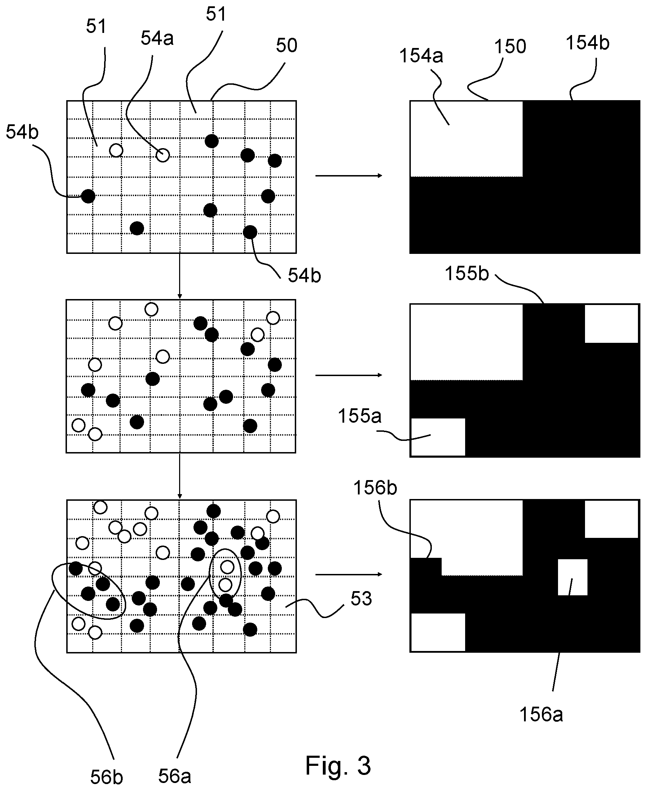

The charged particle microscope M according to the invention, and of which an embodiment is shown in Fig. 1, thus comprises an optics column O, including a charged particle source 4, a final probe forming lens 6 and a scanner 8, for focusing a beam B of charged particles emitted from said charged particle source 4 onto a sample. The apparatus further comprises a sample stage A,H positioned downstream of said final probe forming lens 6 and arranged for holding said sample S. The apparatus furthermore comprises a first detector 22 for detecting emissions of a first type originating from said sample in response to the incidence of charged particles B emitted from said charged particle source 4. In the embodiment shown, the first detector 22 is the analysis device 22, which -as mentioned before- might be a combined scintillator/photomultiplier or EDS (Energy-Dispersive X-Ray Spectroscopy) module. In a preferred embodiment, said first detector is an EDS. Furthermore, the apparatus according to the invention comprises the control device 20 that is connected (by means of lines 20') to said first detector 22 (schematically shown). According to the invention, said charged particle microscope M is arranged for executing the method according to the invention, which will later be explained by means of Figs. 3 to Fig. 4.

Now first referring to Fig. 2, another embodiment of an apparatus according to the invention is shown. Fig. 2 (not to scale) is a highly schematic depiction of a charged-particle microscope M according to the present invention; more specifically, it shows an embodiment of a non-transmission-type microscope M, which, in this case, is a SEM (though, in the context of the current invention, it could just as validly be an ion-based microscope, for example). In the Figure, parts which correspond to items in Figure 1 are indicated using identical reference symbols, and will not be separately discussed here. Additional to Figure 1 are (*inter alia*) the following parts:
- 2a: A vacuum port, which may be opened so as to introduce/remove items (components, samples) to/from the interior of vacuum chamber 2, or onto which, for example, an ancillary device/module may be mounted. The microscope M may comprise a plurality of such ports 2a, if desired;
- 10a, 10b: Schematically depicted lenses / optical elements in illuminator 6;
- 12: A voltage source, allowing the sample holder H, or at least the sample S, to be biased (floated) to an electrical potential with respect to ground, if desired;
- 14: A display, such as a FPD or CRT;
- 22a, 22b: A segmented electron detector 22a, comprising a plurality of independent detection segments (*e.g.* quadrants) disposed about a central aperture 22b (allowing passage of the beam B). Such a detector can, for example, be used to investigate (the angular dependence of) a flux of output (secondary or backscattered) electrons emerging from the sample S.

Thus the charged particle microscope M as shown in Fig. 2 comprises an optics column O, including a charged particle source 4, a final probe forming lens 6, 10a, 10b and a scanner 8, for focusing a beam B of charged particles emitted from said charged particle source 4 onto a sample S. The apparatus further comprises a sample stage A,H positioned downstream of said final probe forming lens 6 and arranged for holding said sample S. The apparatus furthermore comprises a first detector 22 for detecting emissions of a first type originating from said sample in response to the incidence of charged particles B emitted from said charged particle source 4. In the embodiment shown, the first detector 22 is said analysis device 22, which -as mentioned before-might be a combined scintillator/photomultiplier or EDS (Energy-Dispersive X-Ray Spectroscopy) module. In an alternative embodiment, the first detector 22 may be the segmented detector 22a, 22b. In a preferred embodiment, said first detector is an EDS. Furthermore, the apparatus according to the invention comprises said control device 20 that is connected (by means of lines 20') to said first detector 22.

The apparatus shown in Fig. 1 and Fig. 2 may be used in examining a sample with a method according to the invention. Several embodiments of the method according to the invention are shown in Fig. 3 to Fig. 4. In general, these methods all comprise the steps of:
- Providing a charged particle beam B and scanning said beam B over an area of the sample S
- Detecting spectral emissions from the sample S in response to the beam B being scanned over the area of the sample;
- Identifying a first plurality of substantially similar spectral emissions and determining a first chemical element associated with said first plurality of substantially similar spectral emissions;
- Providing a first base spectral number value associated with said first determined chemical element, wherein said first base spectral number value is related to the number of similar spectral emissions that are required for confidently determining said first chemical element;
- Dividing at least a part of the scanned area of the sample into a first number of segments associated with said first chemical element, wherein said first base spectral number value is used for defining a size of each of said first number of segments; and
- Providing a graphical representation of the sample, wherein said graphical representation includes said first chemical element and corresponding segments.

Now referring to Fig. 3, a first embodiment of the method according to the invention is schematically shown. Fig. 3 schematically shows, in the left hand side, an area 50 of a sample to be examined with acquired data 54a, 54b, and on the right hand side a representation 150 of the acquired data.

The area 50 of the sample is scanned with a beam of charged particles. The first detector, for example an EDS detector as described with reference to Fig. 1 and Fig. 2, is used to detect emissions of a first type from the sample in response to the beam scanned over the area 50 of the sample. The detector has a pixel size 51, and events can be recorded per pixel. In principle, it is also possible to record events with sub-pixel accuracy, in a manner that is known to those skilled in the art. The emissions/events are schematically indicated by data points 54a (white dots) and 54b (black dots) in Fig. 3. Data points 54a represent a different emission than data points 54b, i.e. meaning that the detector detects a different signal at these different locations. For example, this could be the result of the white points 54a representing a first material (or chemical element), and the black points 54b representing a second material (that is different from said first material). As shown in the left hand side sequence, from top to bottom, the data information 54a, 54b is relatively sparse in the beginning, and increases as scanning is continued. In the top most step, a first plurality of substantially similar spectral emissions 54a is identified. Additionally, in this embodiment, a second plurality of substantially similar spectral emissions 54b is identified as well. For these similar spectral emissions 54a, 54b, a first chemical element and a second chemical element can be determined, respectively. For example, it can be found that the first chemical element is silicon (Si) and the second chemical element is iron (Fe).

In the embodiment shown, a subsequent step is to provide a first base spectral number value associated with said first determined chemical element, wherein said first base spectral number value is related to the number of similar spectral emissions that are required for confidently determining said first chemical element. In this embodiment, a further step of providing a second base spectral number value associated with said second determined chemical element as well. The first and second base spectral number value may be provided by means of a look-up table. For example, and using controller/processor 20 of the charged particle microscope M. The first and second base spectral number value may, and in practice will, be non-identical to each other. The first and second base spectral number value indicate how many events are needed to confidently indicate the presence of a first and second chemical element, respectively. When the first base spectral number value is lower than the second base spectral number value, it means that less events are needed for confidently identifying the first chemical element compared to the second chemical element. According to the method as defined herein, the scanned area of the sample is divided into a first number of segments associated with said first chemical element, wherein said first base spectral number value is used for defining a size of each of said first number of segments. In the embodiment shown, the scanned area of the sample is also divided into a second number of segments associated with said second chemical element, wherein said second base spectral number value is used for defining a size of each of said second number of segments.

This aspect of the method as defined herein is shown in the right-hand side of Fig. 3, which shows the representation 150 of the acquired data. In this example, it is assumed that the first base spectral number value is "2"; and that the second base spectral number value is "4". In other words, 2 white dots 54a are needed to successfully identify the first chemical element, and 4 black dots 54b are needed to successfully identify the second chemical element.

This means that as data is coming in (as indicated from top to bottom, left-hand side of Fig. 3) the graphical representation can be made, and updated accordingly (as indicated from top to bottom, right-hand side of Fig. 3). Here, use is made of the base spectral number values associated with the identified chemical elements. Thus, in the upper most data set, the two white dots are grouped together to form a single segment 154a (as the base spectral number value is "2"), and the eight black dots are also grouped together. In this case, the black dots are grouped together into a single, larger segment 154b, as the black dots are connected to each other. In principle, the black segment 154b can be viewed as being composed of two sub-segments that are connected to each other (as the base spectral number value is "4", and eight black dots are present in total).

One skilled in the art will understand that the acquired data 54a, 54b can, in principle have many values (not only black or white), and that the representation values can be arbitrarily selected in dependence of the desired application. This means that further chemical elements may be present, each of which has it's own respective further base spectral number value that can be used to create segments. The example shown is merely an illustration of a single possibility and is not intended to be limited.

Now, as the number of data points 54a, 54b increases (in the sequence of Fig. 3: from top to bottom) it becomes possible to increase the accuracy of the graphical representation 150 by repeating the steps of grouping similar events together and creating segments in the graphical representation 150. Thus, with the base spectral number value for the white dots being equal to two, it becomes possible to add further segments 155a in the graphical representation 150.

Note that, even though the base spectral number value for the white dots is equal to "2", and the same number is used to create segments 154a, 155a, the actual size of the different segments 154a, 155a can vary.

Thus, it can be seen that the granularity and accuracy of the represented data (right hand side) increases as more data points are acquired: the image becomes more detailed and contains more information. Note also that segments previously indicated as being "white" can be changed (partly) into "black". Notice that cluster 56b (a group of four black dots, being equal to the base spectral number value) is used to generate a further segment 156b in the graphical representation. Similarly, the two white dots 56a are equal to the base spectral number value for white and can be grouped, thus leading to segment 156a. Thus, the size and number of the segments may vary. In the particular example a single, irregular black segment is formed, due to the fact that most black dots are seemingly connected to each other. This may vary, in practice, of course, and this will be understood by those skilled in the art.

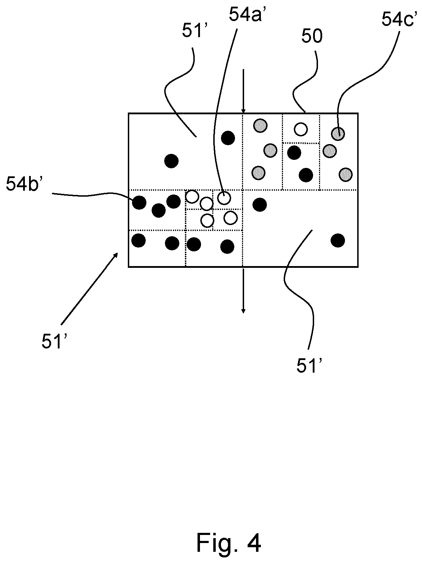

Fig. 4 shows that, in an embodiment, the division into segments 51' for a first element 54a', a second element 54b' and a further element 54c' may lead to differently sized segments 51'. Here, the first element 54a' has a first base spectral number value of "1", the second element 54b' has a second base spectral number value of "2", and the further element 54c' has a further base spectral number value of "3". The controller/processor 20 can thus be arranged for identifying clusters of elements that add up to the required base spectral number value, and create a single segment for that cluster. This may lead to a variety of segments in the graphical representation, wherein segments vary in size and shape. This holds true for similar elements (see for example the differently sized segments for the black dots 54b'). But also different elements can have differently sized segments, or even equally sized segments.

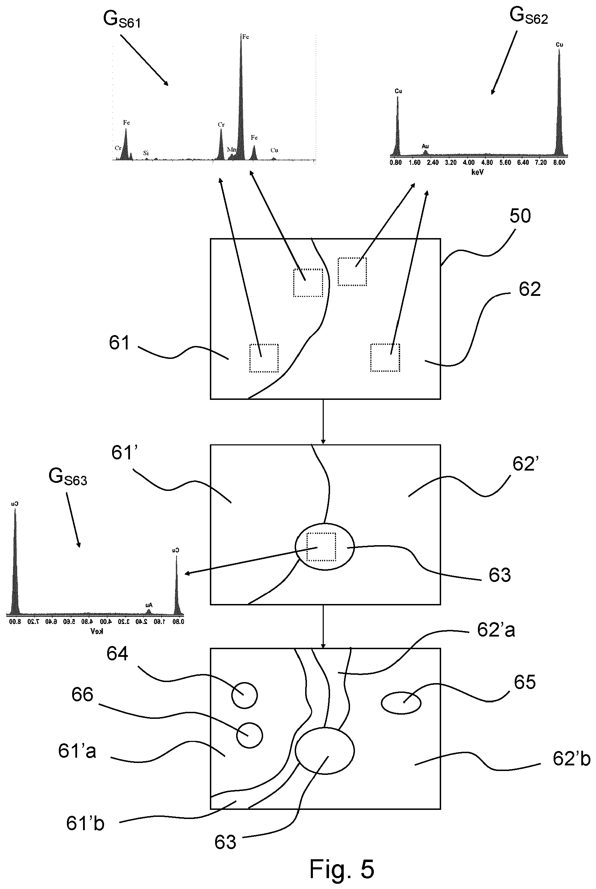

Fig. 5 shows that the segments and sub-segments do not have to have a regular shape. In the beginning, the area 50 of the sample is scanned, and spectral information Gₛ₆₁, Gₛ₆₂ is used to identify chemical elements and divide the area 50 into segments 61, 62 using base spectral number value. Here, the shape of the segments 61, 62 is irregular, i.e. not square or rectangular. As more information is obtained during further scanning, the further spectral information Gₛ₆₃ is used to adjust the shape of segments 61, 62 into adjusted segments 61', 62' and even a further segment 63 is created. Additional segments 64, 65, 66 are also introduced. These segments 61-66 (including adjusted segments 61', 62') can then be divided into sub-segments 61'a, 61'b, 62'a, 62'b, for example, as shown in Fig. 5, when more data is coming in and further chemical elements are identified.

It is conceivable that the area 50 to be scanned is scanned multiple times to obtain the desired data quantity. Scanning multiple times may include scanning only a part of the area 50 of the sample. For example it is conceivable that, based on a first scan (or first set of scans), regions of interest and regions of non-interest are defined, and that only regions of interest are scanned in a second scan (or second set of scans). This increases the efficiency of the method. In particular, the regions of interest may be defined using the data obtained from the emissions of the second type, i.e. the EM data may be used to define regions of interest that are in particular scanned for obtaining EDS data.

The invention has been explained above by means of several embodiments. The desired protection is defined by the attached claims.

## Claims

1. A method of examining a sample using a charged particle microscope,
comprising:
- Providing a charged particle beam (B) and scanning said beam over an area of the sample (S);
- Detecting spectral emissions from the sample (S) in response to the charged particle beam (B) being scanned over the area of the sample;
- Identifying a first plurality of substantially similar spectral emissions and determining a first chemical element associated with said first plurality of substantially similar spectral emissions;
- Providing a first base spectral number value associated with said first determined chemical element, wherein said first base spectral number value is related to the number of similar spectral emissions that are required for identification of said first chemical element;
- Dividing at least a part of the scanned area of the sample into a first number of segments associated with said first chemical element, wherein said first base spectral number value is used for defining a size of each of said first number of segments; and
- Providing a graphical representation of the sample, wherein said graphical representation includes said first chemical element and corresponding segments
**Characterised in that** the method further comprises:
- Identifying a second plurality of substantially similar spectral emissions and determining a second chemical element associated with said second plurality of substantially similar spectral emissions;
- Providing a second base spectral number value associated with said second determined chemical element, wherein said second base spectral number value is related to the number of similar spectral emissions that are required for identification of said second chemical element; and
- Dividing at least a part of the scanned area of the sample into a second number of segments associated with said second chemical element, wherein said second base spectral number value is used for defining a size of each of said second number of segments, wherein said second base spectral number value differs from said first base spectral number value, and said size of each of said second number of segments differs from said size of each of said first number of segments.

2. Method according to claim 1, comprising the steps of
- Identifying at least one further plurality of substantially similar spectral emissions and determining a further chemical element associated with said further plurality of substantially similar spectral emissions;
- Providing, for each of the at least one further chemical elements, a respective further base spectral number value associated with said respective further determined chemical element, wherein said respective further base spectral number value is related to the number of similar spectral emissions that are required for identification of said respective further chemical element; and
- Dividing at least a part of the scanned area of the sample into a corresponding set of further number of segments, each set associated with a respective further chemical element, wherein said further base spectral number value is used for defining a size of each of said corresponding further number of segments.

3. Method according to claims 1 or 2, comprising the step of updating and/or modifying at least one segment in response to the beam being scanned over the sample.

4. A charged particle microscope for examining a sample, comprising:
- an optics column, including a charged particle source, a final probe forming lens and a scanner, for focusing a beam of charged particles emitted from said
charged particle source onto a sample;
- a sample stage positioned downstream of said final probe forming lens and arranged for holding said sample;
- a first detector for detecting emissions of a first type originating from said sample in response to the incidence of charged particles emitted from said charged particle source; and
- a control unit and a processing device connected to said first detector;
- wherein said charged particle microscope is arranged for executing the method as defined in claims 1-3.

## Patentansprüche

1. Verfahren zum Untersuchen einer Probe unter Verwendung eines Teilchenstrahlmikroskops,
umfassend:
- Bereitstellen eines Strahls geladener Teilchen (B) und Rastern des Strahls über einen Bereich der Probe (S);
- Erfassen spektraler Emissionen von der Probe (S) als Reaktion darauf, dass der Strahl geladener Teilchen (B) über den Bereich der Probe gerastert wird;
- Identifizieren einer ersten Vielzahl im Wesentlichen ähnlicher spektraler Emissionen und Bestimmen eines ersten chemischen Elements, das der ersten Vielzahl im Wesentlichen ähnlicher spektraler Emissionen zugeordnet ist;
- Bereitstellen eines ersten spektralen Basiszahlwerts, der dem ersten bestimmten chemischen Element zugeordnet ist, wobei sich der erste spektrale Basiszahlwert auf die Anzahl ähnlicher spektraler Emissionen bezieht, die für die Identifizierung des ersten chemischen Elements erforderlich sind;
- Unterteilen zumindest eines Teils des gerasterten Bereichs der Probe in eine erste Anzahl von Segmenten, die dem ersten chemischen Element zugeordnet sind, wobei der erste spektrale Basiszahlwert zum Definieren einer Größe jedes Segments der ersten Anzahl von Segmenten verwendet wird; und
- Bereitstellen einer grafischen Darstellung der Probe, wobei die grafische Darstellung das erste chemische Element und entsprechende Segmente beinhaltet,
**dadurch gekennzeichnet, dass** das Verfahren ferner umfasst:
- Identifizieren einer zweiten Vielzahl im Wesentlichen ähnlicher spektraler Emissionen und Bestimmen eines zweiten chemischen Elements, das der zweiten Vielzahl im Wesentlichen ähnlicher spektraler Emissionen zugeordnet ist;
- Bereitstellen eines zweiten spektralen Basiszahlwerts, der dem zweiten bestimmten chemischen Element zugeordnet ist, wobei sich der zweite spektrale Basiszahlwert auf die Anzahl ähnlicher spektraler Emissionen bezieht, die für die Identifizierung des zweiten chemischen Elements erforderlich sind; und
- Unterteilen zumindest eines Teils des gerasterten Bereichs der Probe in eine zweite Anzahl von Segmenten, die dem zweiten chemischen Element zugeordnet sind, wobei der zweite spektrale Basiszahlwert zum Definieren einer Größe jedes Segments der zweiten Anzahl von Segmenten verwendet wird, wobei sich der zweite spektrale Basiszahlwert von dem ersten spektralen Basiszahlwert unterscheidet und sich die Größe jedes Segments der zweiten Anzahl von Segmenten von der Größe jedes Segments der ersten Anzahl von Segmenten unterscheidet.

2. Verfahren nach Anspruch 1, das die Schritte umfasst:
- Identifizieren mindestens einer weiteren Vielzahl im Wesentlichen ähnlicher spektraler Emissionen und Bestimmen eines weiteren chemischen Elements, das der weiteren Vielzahl im Wesentlichen ähnlicher spektraler Emissionen zugeordnet ist;
- Bereitstellen, für jedes der mindestens einen weiteren chemischen Elemente, eines jeweiligen weiteren spektralen Basiszahlwerts, der dem jeweiligen weiteren bestimmten chemischen Element zugeordnet ist, wobei sich der jeweilige weitere spektrale Basiszahlwert auf die Anzahl ähnlicher spektraler Emissionen bezieht, die für die Identifizierung des jeweiligen weiteren chemischen Elements erforderlich sind; und
- Unterteilen zumindest eines Teils des gerasterten Bereichs der Probe in entsprechende Sätze weiterer Segmente, wobei jeder Satz einem jeweiligen weiteren chemischen Element zugeordnet ist, wobei jeweils der jeweilige weitere spektrale Basiszahlwert zum Definieren einer Größe jedes Segments des jeweiligen Satzes verwendet wird.

3. Verfahren nach Anspruch 1 oder 2, das den Schritt des Aktualisierens und/oder Modifizierens mindestens eines Segments als Reaktion darauf umfasst, dass der Strahl über die Probe gerastert wird.

4. Teilchenstrahlmikroskop zum Untersuchen einer Probe, umfassend:
- eine Optiksäule, die eine Quelle geladener Teilchen, eine sondenbildende Endlinse und einen Scanner beinhaltet, zum Fokussieren eines Strahls geladener Teilchen, der von der
Quelle geladener Teilchen emittiert wird, auf eine Probe;
- einen Probentisch, der der sondenbildenden Endlinse nachgeordnet positioniert ist und zum Halten der Probe angeordnet ist;
- einen ersten Detektor zum Erfassen von Emissionen eines ersten Typs, die von der Probe stammen, als Reaktion auf das Auftreffen von geladenen Teilchen, die von der Quelle geladener Teilchen emittiert werden; und
- eine Steuereinheit und eine Verarbeitungsvorrichtung, die mit dem ersten Detektor verbunden sind;
- wobei das Teilchenstrahlmikroskop dazu eingerichtet ist, das Verfahren nach den Ansprüchen 1 bis 3 auszuführen.

## Revendications

1. Procédé d'examen d'un échantillon à l'aide d'un microscope à particules chargées, comprenant :
- la fourniture d'un faisceau de particules chargées (B) et le balayage de ce faisceau sur une zone de l'échantillon (S) ;
- la détection des émissions spectrales de l'échantillon (S) en réponse au faisceau de particules chargées (B) balayant la zone de l'échantillon ;
- l'identification d'une première pluralité d'émissions spectrales essentiellement similaires et la détermination d'un premier élément chimique associé à ladite première pluralité d'émissions spectrales essentiellement similaires ;
- la fourniture d'une première valeur numérique spectrale de base associée audit premier élément chimique déterminé, dans laquelle cette première valeur numérique spectrale de base est liée au nombre d'émissions spectrales similaires nécessaires à l'identification de ce premier élément chimique ;
- la division d'au moins une partie de la zone balayée de l'échantillon en une premier nombre de segments associés audit premier élément chimique, dans laquelle ladite première valeur de nombre spectral de base est utilisée pour définir la taille de chacun desdits premiers nombres de segments ; et
- la fourniture d'une représentation graphique de l'échantillon, dans laquelle ladite représentation graphique comprend ledit premier élément chimique et les segments correspondants
**Caractérisé en ce que** le procédé comprend en outre :
- l'identification d'une deuxième pluralité d'émissions spectrales essentiellement similaires et la détermination d'un second élément chimique associé à ladite deuxième fraction d'émissions spectrales substantiellement similaires ;
- la fourniture d'une deuxième valeur numérique spectrale de base associée audit deuxième élément chimique déterminé, dans laquelle ladite deuxième valeur numérique spectrale de base est liée au nombre d'émissions spectrales similaires qui sont nécessaires à l'identification dudit deuxième élément chimique ; et
- la division d'au moins une partie de la zone balayée de l'échantillon en un deuxième nombre de segments associés audit deuxième élément chimique, dans laquelle ladite deuxième valeur numérique spectrale de base est utilisée pour définir la taille de chacun dudit deuxième nombres de segments, dans lequel ladite deuxième valeur numérique spectrale de base est différente de ladite première valeurnumérique spectrale de base, et ladite taille de chacun dudit deuxième nombre de segments diffère de ladite taille de chacun dudit premier nombre de segments.

2. Procédé selon la revendication 1, comprenant les étapes consistant à
- Identifier au moins une autre pluralité d'émissions spectrales essentiellement similaires et déterminer un autre élément chimique associé à ladite autre puralité d'émissions spectrales essentiellement similaires ;
- Fournir, pour chacun des autres éléments chimiques, une autre valeur numérique spectrale de base respective associée audit autre élément chimique respectif déterminé, dans lequel ladite autre valeur numérique spectale de base respective est liée au nombre d'émissions spectrales similaires qui sont nécessaires à l'identificationdudit autre élément chimique respectif ; et
- Diviser au moins une partie de la zone balayée de l'échantillon en un ensemble correspondant d'un autre nombre de segments, chaque ensemble associé à un autre élément chimique respectif, ladite autre valeur numérique spectrale de base étant utilisée pour définir la taille de chacun desdits autres nombres de segments correspondants.

3. Procédé selon la revendication 1 ou 2, comprenant l'étape de mise à jour et/ou de modification d'au moins un segment en réponse au faisceau balayant l'échantillon.

4. Un microscope à particules chargées pour l'examen d'un échantillon, comprenant :
- une colonne optique comprenant une source de particules chargées, une lentille finale de formation de sonde et un scanner, pour focaliser un faisceau de particules chargées émises par ladite
source de particules chargées sur un échantillon ;
- une étape d'échantillonnage positionnée en aval de ladite lentille finale formant sonde et agencée pour maintenir ledit échantillon ;
- un premier capteur destiné à détecter les rayonnements d'un premier type provenant de cet échantillon en réponse à l'incidence des particules chargées émises par ladite source de particules chargées ; et
- une unité de commande et un dispositif de traitement connectés audit premier capteur ;
- dans lequel ledit microscope à particules chargées est agencé pour exécuter le procédé tel que défini dans les revendications 1 à 3.
